# EUROPEAN PATENT SPECIFICATION

(11) **EP 1 665 917 B1**
(45) Date of publication and mention of the grant of the patent: **20.12.2006**
(21) Application number: 04725932.0
(22) Date of filing: 06.04.2004
(51) Int. Cl.: H05K 9/00

(54) **AUTOMATIC ELECTROMAGNETIC SEALING SYSTEM FOR APERTURES IN ELECTROMAGNETIC SHIELDS**
AUTOMATISCHES SYSTEM ZUR ELEKTROMAGNETISCHEN ABSCHIRMUNG FÜR ABSCHIRMTÜREN
SYSTEME DE JOINT ELECTROMAGNETIQUE AUTOMATIQUE POUR OUVERTURES DANS DES BLINDAGES ELECTROMAGNETIQUES

(30) Priority: 05.09.2003 IT MI20031707
(43) Date of publication of application: 07.06.2006
(73) Proprietor: ITEL Telecomunicazioni S.r.l., 70037 Ruvo di Puglia (BA) (IT)
(72) Inventor: DIAFERIA, Leonardo, 70037 Ruvo di Puglia (IT)
(74) Representative: Coggi, Giorgio
(86) International application number: PCT/EP2004/003648
(87) International publication number: WO 2005/025286

(56) References cited:
- EP-A- 0 030 529
- US-A- 3 507 974
- US-A- 4 399 317
- US-A- 4 525 595
- US-A- 5 214 241

## Description

The present invention relates to a system designed to automate the electromagnetic seal of an electromagnetic shield, in particular for electromagnetically shielded chambers, such as, for example, shielded chambers in which magnetic resonance equipment is installed.

As is known, a shielded chamber consists of walls of metal material designed to provide a shield against electromagnetic wave radiation in various frequency ranges, so as to electromagnetically insulate the inside of the chamber from the outside environment and vice versa.

Shielded walls are usually provided with apertures to allow access to the chamber. Said apertures are closed by means of movable closing elements such as doors, hatches, windows and the like, also made of conductive, electromagnetically shielding material.

To ensure that the shielded chamber is electromagnetically sealed, electromagnetic waves must be prevented from passing though the gaps formed between the aperture and the relative movable closing element. For this purpose, electrically conductive metal contacts are provided, commonly called fingers, designed to establish an electrical contact between the fixed structure of the chamber and the movable closing elements, so as to ensure the continuity of the electromagnetic shield formed by the shielded chamber.

These fingers are usually in the form of flexible metal plates installed in the jamb which defines the aperture of the chamber, so as to press against the peripheral edge of the movable closing element, when it is in the closed position.

It is clear that closing of these movable closing elements according to the prior art is very awkward and difficult because the elastic resistance of the fingers must be overcome.

US 3,507,974 discloses an electromagnetic shield door structure wherein the door has a peripheral groove about its edge and elongated finger stock within the groove for electromagnetically shielding the door when in closed position.

The object of the present invention is to eliminate the drawbacks of the prior art by providing an electromagnetic sealing system for an electromagnetic shield that is efficient and at the same time practical and convenient for the user.

Another object of the present invention is to provide such an electromagnetic sealing system for an electromagnetic shield that is versatile and able to ensure automatically the electromagnetic seal of a shield.

Yet another object of the present invention is to provide such an electromagnetic sealing system that is cheap and easy to produce.

These objects are achieved according to the invention with the characteristics listed in appended independent claim 1.

Advantageous embodiments of the invention are apparent from the dependent claims.

The electromagnetic sealing system for an electromagnetic seal according to the invention comprises:
- an aperture defined by a jamb or frame of a fixed wall,
- a movable closing element defined by a peripheral rim or frame designed to close said aperture, and
- at least one conductive contact element disposed between the jamb and the frame so as to create a continuous electrical contact between the fixed wall and the movable closing element, when said movable closing element is in the closed position.

The peculiar characteristic of the invention is represented by the fact that the electromagnetic sealing system further comprises operating means designed to act on said conductive contact element to bring it from a position of not providing an electromagnetic seal in which it does not create a continuous electrical contact between the fixed wall and the movable closing element, to an electromagnetically sealing position in which it creates a continuous electrical contact between the fixed wall and the movable closing element.

A centralised control unit is advantageously provided which activates all the operating means simultaneously and a user interface operated by the user to control the centralised control unit is also provided.

In this manner, when the conductive contact element is in a position not providing an electromagnetic seal, the movable closing element can be opened/closed without any difficulty. Once the movable closing element is in the closed position, the operating means are activated so as to bring the conductive contact element into the electromagnetic sealing position.

Further characteristics of the invention will be made clearer by the detailed description that follows, referring to a purely exemplary and therefore nonlimiting embodiment thereof, illustrated in the appended drawings, in which:
Figure 1 is a plan view of a shielded chamber provided with a door in the open position;
Figure 2 is a front view of the shielded chamber of Figure 1, illustrating the door in the closed position;
Figure. 3 is a block diagram illustrating the electromagnetic sealing system according to the invention applied to the door of the shielded chamber of Figure 2, shown in the closed position and in a condition not providing an electromagnetic seal;
Figure. 4 is a block diagram like Figure 3, in which the door is in the closed position and in an electromagnetically sealing condition;
Figure 5 is an enlarged, broken off sectional view taken along the sectional plane V-V of Figure 3, illustrating an embodiment of the operating means of the sealing system according to the invention in a condition not providing an electromagnetic seal; and
Figure 6 is an enlarged, broken off sectional view taken along the plane of section VI-VI of Figure 4, illustrating the operating means of Figure 5 in a condition providing an electromagnetic seal.

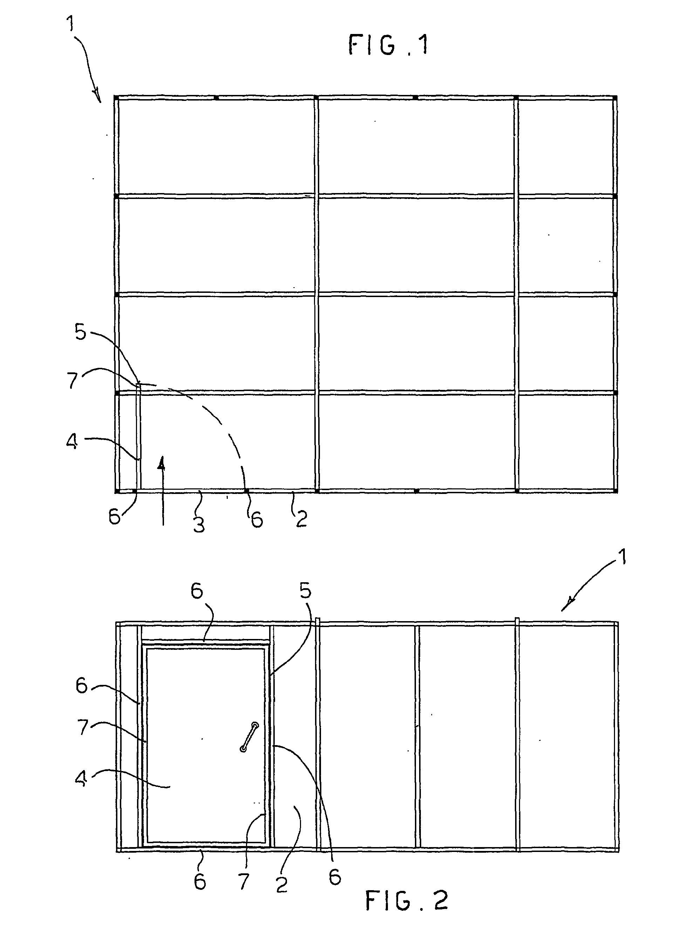

The electromagnetic sealing system according to the invention is described with the aid of the figures. With reference for now to Figures 1 and 2, a shielded chamber 1 is illustrated, such as, for example, a chamber designed to house magnetic resonance devices and the like which must be placed in a shielded environment so as not to be subj ected to outside disturbances caused by electromagnetic radiation.

The chamber 1 has a shielded wall 2 in which an aperture 3 is defined for access to the inside of the chamber 1. The aperture 3 is closed by a movable closing element 4. In the figures the movable element 4 has been exemplified as a hinged door, but it is clear that it can be a window or a panel and can be moved by translation, without departing from the scope of the invention.

The aperture 3 is defined by a rectangular jamb 6 integral with the fixed wall 2. The door 4 has a frame 7 disposed in its rectangular peripheral rim. It is clear that the jamb 6 can be integral with the wall 2 and the frame 7 can be integral with the door 4.

Both the wall 2 and the door 4 are usually made of conductive material that acts as a shield against electromagnetic radiation at radio frequencies. For example, the wall 2 can be made of metallic material and the door 4 can be made of metallic material or conductive polymer.

Therefore, to ensure the continuity of the shielding of the wall 2, a contact element 5 which extends along the whole perimeter of the door 4 is interposed in the gap formed between the jamb 6 of the wall 2 and the frame 7 of the door 4. The contact element 5 is generally of conductive material, so as to ensure a continuous electrical contact between the frame 7 of the door and the jamb 6 of the wall. For example, said conductive contact element 5 can be a thin metal plate or finger or even a conductive polymer gasket.

By way of example, in the figures a conductive contact element in the form of a thin blade 5 disposed in the peripheral rim of the door frame 7 has been illustrated; however, it can be placed in the jamb 6 of the wall.

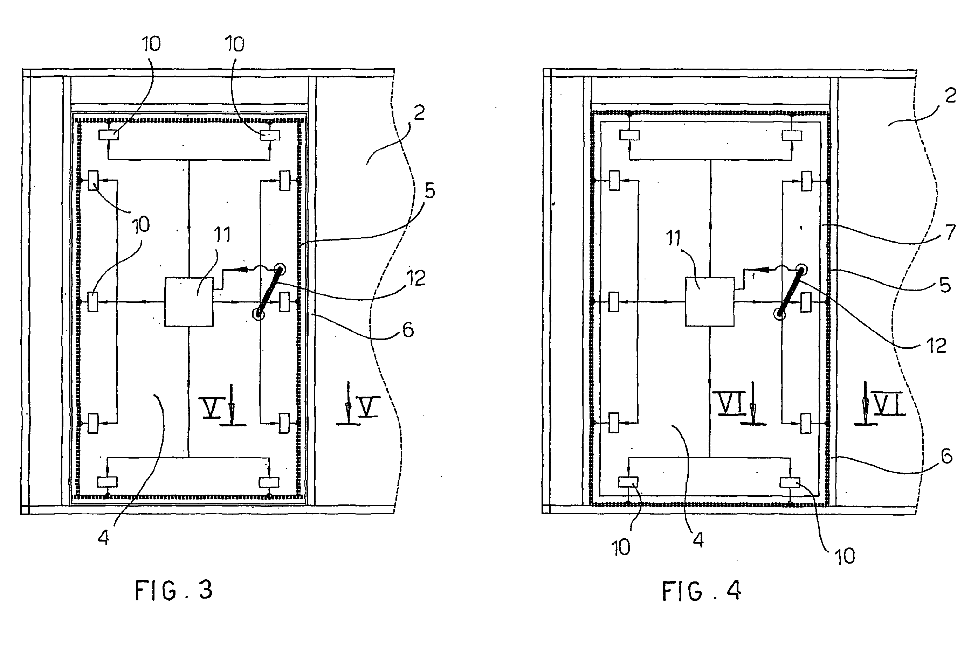

With reference to Figures 3 and 4, the sealing system according to the invention has a plurality of operating means 10 designed to act on the thin blade 5 to bring it from a non sealing position (Figure 3) in which the blade 5 does not ensure a continuity of electrical contact between the frame 7 and the jamb 6 to a sealing position (Figure 4) in which the blade 5 ensures a continuous electrical contact between the frame 7 and the jamb 6.

In the figures the blade 5 has been shown mounted in the frame 7 of the door. Therefore, when the blade 5 is in the non-sealing position (Figure 3) it is at a distance from the jamb 6. On the other hand, when the blade 5 is in the sealing position (Figure 4) it is in close contact with the jamb 6.

The operating means 10 are suitably distributed along the perimeter of the door 4 so as to ensure an even movement of the blade 5 which is suitably flexible.

The operating means 10 are activated simultaneously by a central control unit 11 which receives a control signal from a user interface 12 controlled by a user.

In Figures 3 and 4 the user interface 12 has been represented as handle of the door 4 which can be operated by the user to control the operating means 10. It is clear that the user interface 12 can be realized by means of a pushbutton, a remote control or any other type of local or remote control system, cabled or wireless, suitable to control the control unit 11.

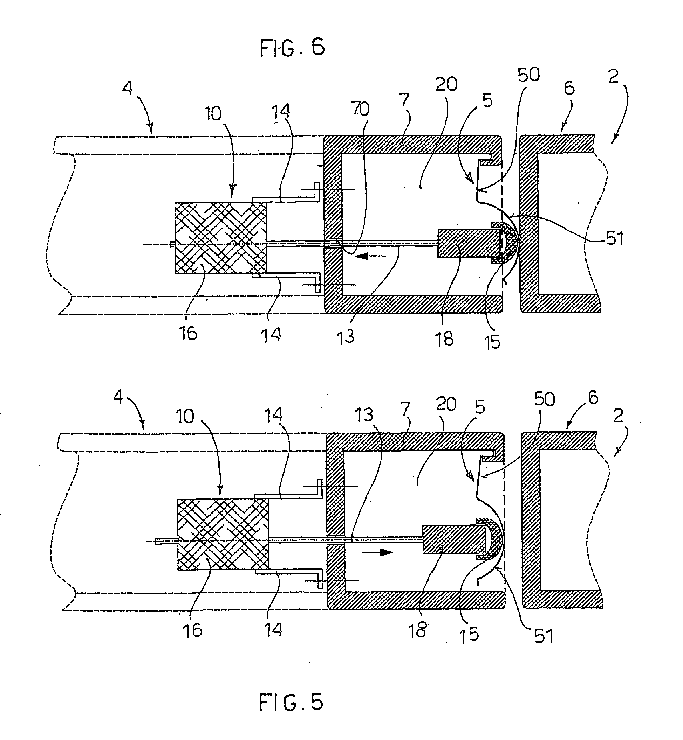

With reference to Figures 5 and 6, the operating means 10 are described. In this example the frame 7 of the door 2 is a metal section having a substantially C-shaped cross section so as to define a recessed seat 20. Inside the seat 20 of the frame 7 there is disposed a thin blade 5 which has a flat portion 50 with one end fixed to the frame 7 and a curved portion 51 with an inward facing concavity.

The operating means 10 is in the form of a linear actuator consisting of a cylinder 16 and a piston 18 provided with a rod 13 which can move linearly with a reciprocating movement inside the cylinder 16 so as to pass from a retracted position (Figure 5) to an advanced position (Figure 6).

The cylinder 16 is placed inside the door 4 and fixed by means of brackets 14 to the frame 7. The rod 13 of the piston 18 passes through a through hole 70 formed in the frame 7 so that the piston 18 is situated in the seat 20 of the frame 7.

The piston 18 is provided with a rounded head 15 intended to act against the concave part of the rounded portion 51 of the blade 5.

In this manner, when the rod 13 of the piston is in the retracted position (Figure 5), the head 15 of the piston does not act on the blade 5 and the blade 5 remains inside the seat 20, not interfering with the jamb 6. On the other hand, when the rod 13 of the piston is in the advanced position (Figure 6), the head 15 of the piston acts against the blade 5 pushing it out of the seat 20 so that it comes into close contact against the jamb 6.

The operating means 10 can be of any type, such as electromagnetic, pneumatic, hydraulic, mechanical, etc.

In the case of operating means 10 of the electromagnetic type, the rod 13 of the piston is operated by a magnetic field generated by an inductance placed in the cylinder bore 16. In this case the control unit 11 is represented by an electrical supply which is responsible for sending a suitable electric current to supply the inductance.

In the case of operating means 10 of the pneumatic or hydraulic type, the rod 13 of the piston is operated by compressed air or compressed oil in the cylinder bore 16. In this case the control unit 11 is represented by a pneumatic or hydraulic system which is responsible for feeding/discharge of the fluid to/from the cylinder bores 16.

In the case of operating means 10 of the mechanical type, the piston 18 can be driven with a rectilinear reciprocating movement by means of a rack driven by a pinion or by means of a screw driven by a lead nut. In this case the control unit 11 is represented by driver which simultaneously starts up electric motors which set the pinions or lead screws of the drive means 10 in rotation. Alternatively, the control unit 11 is represented by a mechanical driving gear system which simultaneously sets in rotation the pinions or lead screws of the operating means 10, though activation of the user interface 12.

In a further embodiment of the invention in which the contacting conductive element comprises a conductive polymer gasket, the operating means are formed by means for introducing/expelling air into/from an air space formed in the gasket to inflate or deflate it. These air introduction means can again be pistons which act with an airtight seal in said air space.

In this manner, when the air space of the gasket is inflated, an electromagnetic seal is created between the movable closing element 4 and the fixed part 2. When, on the other hand, the air space of the gasket is deflated, no electromagnetic seal is created between the movable closing element 4 and the fixed part 2, and thus the movable closing element 4 can move freely into a position of closing or opening with respect to the fixed part 2.

It is clear that in this latter embodiment another conductive contact element 5 can be provided, in contact with the inflatable gasket. As a result the electromagnetic seal of the conductive contact element 5 is obtained by inflation of the air chamber of the gasket, which pushes the conductive contact element 5 into contact with the fixed element 2 of with the movable closing element 4 forming an electromagnetic seal.

Numerous changes and modifications of detail within the reach of a person skilled in the art can be made to the present embodiment of the invention, without thereby departing from the scope of the invention as set forth in the appended claims.

## Claims

1. An electromagnetic sealing system for an electromagnetic shield comprising
- an aperture (3) defined by a jamb or doorpost (6) of a fixed wall (2),
- a movable closing element (4) defined by a peripheral rim or frame (7) able to close said aperture (3), and
- at least one conductive contact element (5) disposed between said jamb (6) and said frame (7) so as to create a continuous electrical contact between the fixed wall (2) and the movable closing element (4), when said movable closing element is in the closed position,
**characterised in that** it further comprises
- operating means (10) comprising linear actuators designed to operate a piston (18) with a reciprocating linear movement, to push said conductive contact element (5) to bring it from a position not providing an electromagnetic seal in which it does not create a continuous electrical contact between the fixed wall (2) and the movable closing element (4), to an electromagnetically sealing position in which it creates a continuous electrical contact between the fixed wall (2) and the movable closing element (4).

2. A system according to claim 1, **characterised in that** it comprises a centralised control unit (11) designed to start up simultaneously said operating means (10):

3. A system according to claim 2, **characterised in that** it comprises a user interface (12) that can be operated by the user to control said centralised control unit (11).

4. A system according to claim 3, **characterised in that** said user interface comprises a handle (12) disposed in said movable closing element (4).

5. A system according to claim 3, **characterised in that** said user interface comprises a pushbutton connected, by a cabled connection, to said centralised control unit (11).

6. A system according to claim 3, **characterised in that** said user interface comprises a remote control communicating, by wireless communication, with said centralised control unit (11).

7. A system according to any one of the preceding claims, **characterised in that** said piston (18) has a substantially curved head (15) which acts against a substantially curved portion (51) of said conductive contact element (5).

8. A system according to claim 7, **characterised in that** said linear actuators (10) comprise a cylinder (16) and a rod (13) movable inside the bore of said cylinder (16) from a retracted position to an advanced position to operate said piston (18).

9. A system according to claim 8, **characterised in that** said linear actuators (10) are of the electromagnetic type and said control unit (11) comprises an electric power supply to electrically supply an inductance disposed inside said cylinder (16).

10. A system according to claim 8, **characterised in that** said linear actuators (10) are of the pneumatic or hydraulic type and that said control unit (11) comprises a pneumatic or hydraulic system to feed/discharge air or oil to/from the bore of said cylinder (16).

11. A system according to any one of the claims 1 to 7, **characterised in that** said linear actuators (10) are of the mechanical type and comprise a rack driven by a pinion to drive said piston (18) which acts against the conductive contact element (5).

12. A system according to any one of the claims 1 to 7, **characterised in that** said linear actuators (10) are of the mechanical type and comprise a screw driven by a lead screw to drive said piston (18) which acts against the conductive contact element (5).

13. A system according to claim 11 or 12, **characterised in that** said control unit (11) comprises a drive which controls at least one electric motor

14. A system according to claim 11 or 12, **characterised in that** said control unit (11) comprises a gear system.

15. A system according to any one of the preceding claims, **characterised in that** said conductive contact element (5) is disposed in said frame (7) of the movable closing element (4) and said operating means (10) are mounted in said movable closing element (4).

16. A system according to any one of claims 1 to 14, **characterised in that** said conductive contact element (5) is disposed in said jamb (6) of the fixed wall (2) and said operating means (10) are mounted in said fixed wall (2).

17. A system according to any one of the preceding claims, **characterised in that** said conductive contact element (5) comprises a metal blade or finger.

18. A system according to any one of claims 1 to 17, **characterised in that** said conductive contact element (5) comprises a conductive polymer gasket,

19. A system according to claim 18, **characterised in that** said operating means (10) comprise air introduction means designed to introduce air into an air space of said gasket so as to inflate it to obtain the electromagnetic seal between the fixed wall (2) and the movable closing element (4), directly or by interposing another conductive contact element (5).

## Patentansprüche

1. Elektromagnetisches Abdichtungssystem für eine elektromagnetische Abschirmung, umfassend:
- eine Öffnung (3), die durch einen Pfosten oder Türpfosten (6) einer festen Wand (2) definiert wird,
- ein bewegliches Schließelement (4), das durch einen Umfangsrand oder - rahmen (7) definiert wird und in der Lage ist, die Öffnung (3) zu verschließen, und
- mindestens ein leitfähiges Kontaktelement (5), das zwischen dem Pfosten (6) und dem Rahmen (7) angeordnet ist, um einen kontinuierlichen elektrischen Kontakt zwischen der festen Wand (2) und dem beweglichen Schließelement (4) zu schaffen, wenn sich das bewegliche Schließelement in der geschlossenen Position befindet,
**dadurch gekennzeichnet, dass** es ferner umfasst
- Betätigungsmittel (10), umfassend lineare Stellglieder, die ausgebildet sind, um einen Kolben (18) mit einer hin- und hergehenden linearen Bewegung zu betätigen, um das leitfähige Kontaktelement (5) anzuschieben, um es von einer Position, die keine elektromagnetische Abdichtung schafft und in welcher es keinen kontinuierlichen elektrischen Kontakt zwischen der festen Wand (2) und dem beweglichen Schließelement (4) herstellt, in eine elektromagnetisch abdichtende Position, in welcher es einen kontinuierlichen elektrischen Kontakt zwischen der festen Wand (2) dem beweglichen Schließelement (4) herstellt, zu bringen.

2. System nach Anspruch 1, **dadurch gekennzeichnet**, das es eine zentrale Steuerungseinheit (11) umfasst, die ausgebildet ist, um die Betätigungsmittel (10) gleichzeitig anzufahren.

3. System nach Anspruch 2, **dadurch gekennzeichnet, dass** es eine Benutzerschnittstelle (12) umfasst, welche durch den Benutzer bedient werden kann, um die zentrale Steuerungseinheit (11) zu bedienen.

4. System nach Anspruch 3, **dadurch gekennzeichnet, dass** die Benutzerschnittstelle einen Griff (12) umfasst, der in dem beweglichen Schließelement (4) angeordnet ist.

5. System nach Anspruch 3, **dadurch gekennzeichnet, dass** die Benutzerschnittstelle einen Drucktaster umfasst, der mittels einer Kabelverbindung an die zentrale Steuerungseinheit (11) angeschlossen ist.

6. System nach Anspruch 3, **dadurch gekennzeichnet, dass** die Benutzerschnittstelle eine Fernsteuerung umfasst, welche mittels drahtloser Kommunikation mit der zentralen Steuerungseinheit (11) kommuniziert.

7. System nach einem beliebigen der vorangehenden Ansprüche, **dadurch gekennzeichnet, dass** der Kolben (18) einen im Wesentlichen gekrümmten Kopf (15) aufweist, der auf einen im Wesentlichen gekrümmten Abschnitt (51) des leitfähigen Kontaktelements (5) einwirkt.

8. System nach Anspruch 7, **dadurch gekennzeichnet, dass** die linearen Stellglieder (10) einen Zylinder (16) und eine Stange (13), die in der Bohrung des Zylinders (16) von einer eingefahrenen Position in eine ausgefahrene Position bewegbar ist, um den Kolben (18) zu betätigen, umfassen.

9. System nach Anspruch 8, **dadurch gekennzeichnet, dass** die linearen Stellglieder (10) von dem elektromagnetischen Typ sind und die Steuerungseinheit (11) eine elektrische Energieversorgung umfasst, um eine Induktanz, die innerhalb des Zylinders (16) angeordnet ist, mit elektrischer Energie zu versorgen.

10. System nach Anspruch 8, **dadurch gekennzeichnet, dass** die linearen Stellglieder (10) vom pneumatischen oder hydraulischen Typ sind und dass die Steuerungseinheit (11) ein pneumatisches oder hydraulisches System umfasst, um Luft oder Öl zu/von der Bohrung des Zylinders (16) zuzuführen/auszutragen.

11. System nach einem beliebigen der Ansprüche 1 bis 7, **dadurch gekennzeichnet, dass** die linearen Stellglieder (10) von dem mechanischen Typ sind und eine Zahnstange umfassen, die durch ein Ritzel angetrieben wird, um den Kolben (18) anzutreiben, welcher auf das leitfähige Kontaktelement (5) einwirkt.

12. System nach einem beliebigen der Ansprüche 1 bis 7, **dadurch gekennzeichnet, dass** die linearen Stellglieder (10) von dem mechanischen Typ sind und eine Schraube umfassen, die durch eine Leitspindel angetrieben wird, um den Kolben (18) anzutreiben, welcher auf das leitfähige Kontaktelement (5) einwirkt.

13. System nach Anspruch 11 oder 12, **dadurch gekennzeichnet, dass** die Steuerungseinheit (11) einen Antrieb umfasst, welcher mindestens einen Elektromotor steuert.

14. System nach Anspruch 11 oder 12, **dadurch gekennzeichnet, dass** die Steuerungseinheit (11) ein Getriebesystem umfasst.

15. System nach einem beliebigen der vorangehenden Ansprüche, **dadurch gekennzeichnet, dass** das leitfähige Kontaktelement (5) in dem Rahmen (7) des beweglichen Schließelements (4) angeordnet ist und die Betätigungsmittel (10) in dem beweglichen Schließelement (4) angebracht sind.

16. System nach einem beliebigen der Ansprüche 1 bis 14, **dadurch gekennzeichnet, dass** das leitfähige Kontaktelement (5) in dem Pfosten (6) der festen Wand (2) angeordnet ist und die Betätigungsmittel (10) in der festen Wand (2) angeordnet sind.

17. System nach einem beliebigen der vorangehenden Ansprüche, **dadurch gekennzeichnet, dass** das leitfähige Kontaktelement (5) eine Metalllamelle oder einen Metallfinger umfasst.

18. System nach einem beliebigen der Ansprüche 1 bis 17, **dadurch gekennzeichnet, dass** das leitfähige Kontaktelement (5) eine leitfähige Polymerdichtung umfasst.

19. System nach Anspruch 18, **dadurch gekennzeichnet, dass** die Betätigungsmittel (10) Lufteinfuhrmittel umfassen, die ausgebildet sind, um Luft in einen Luftraum der Dichtung einzuführen, um diese aufzublasen, um die elektromagnetische Abdichtung zwischen der festen Wand (2) und dem beweglichen Schließelement (4) herzustellen, direkt oder durch Anordnen eines anderen leitfähigen Kontaktelements (5) dazwischen.

## Revendications

1. Système de joint électromagnétique pour un blindage électromagnétique comprenant :
- une ouverture (3) définie par un jambage ou montant de porte (6) d'un mur fixe (2),
- un élément de fermeture mobile (4) défini par un tour ou carde périphérique (7) pouvant fermer ladite ouverture (3), et
- au moins un élément de contact conducteur (5) disposé entre ledit jambage (6) et ledit cadre (7) de sorte à créer un contact électrique continu entre le mur fixe (2) et l'élément de fermeture mobile (4) lorsque ledit élément de fermeture mobile est en position de fermeture,
**caractérisé en ce qu'**il comprend en outre
- des moyens de commande (10) comprenant des actionneurs linéaires conçus pour imprimer à un piston (18) un mouvement linéaire alternatif afin de pousser ledit élément de contact conducteur (5) pour l'amener, depuis une position n'assurant par le joint électromagnétique, dans laquelle il ne crée pas de contact électrique continu entre le mur fixe (2) et l'élément de fermeture mobile (4), jusqu'à une position assurant le joint électromagnétique, dans laquelle il crée un contact électrique continu entre le mur fixe (2) et l'élément de fermeture mobile (4).

2. Système selon la revendication 1, **caractérisé en ce qu'**il comprend une unité de commande centralisée (11) conçue pour mettre en action simultanément lesdits moyens de commande (10).

3. Système selon la revendication 2, **caractérisé en ce qu'**il comprend une interface utilisateur (12) pouvant être commandée par l'utilisateur pour commander ladite unité de commande centralisée (11).

4. Système selon la revendication 3, **caractérisé en ce que** ladite interface utilisateur comprend une poignée (12) disposée dans ledit élément de fermeture mobile (4).

5. Système selon la revendication 3, **caractérisé en ce que** ladite interface utilisateur comprend un bouton poussoir relié par une liaison câblée à ladite unité de commande centralisée (11).

6. Système selon la revendication 3, **caractérisé en ce que** ladite interface utilisateur comprend une commande à distance communicant au moyen d'une communication sans fil avec ladite unité de commande centralisée (11),

7. Système l'une des revendications précédente, **caractérisé en ce que** ledit piston (18) a une tête (15) sensiblement incurvée qui agit sur une partie (51) sensiblement incurvée dudit élément de contact conducteur (5).

8. Système selon la revendication 7, **caractérisé en ce que** lesdits actionneurs linéaires (10) comprennent un cylindre (16) et une tige (13) mobile à l'intérieur de l'alésage dudit cylindre (16) depuis une position rétractée jusqu'à une position avancée pour actionner ledit piston (18).

9. Système selon la revendication 8, **caractérisé en ce que** lesdits actionneurs linéaires (10) sont de type électromagnétique et **en ce que** ladite unité de commande (11) comprend une alimentation électrique pour alimenter en électricité une inductance disposée à l'intérieur dudit cylindre (16).

10. Système selon la revendication 8, **caractérisé en ce que** lesdits actionneurs linéaires (10) sont de type pneumatique ou hydraulique et **en ce que** ladite unité de commande (11) comprend un système pneumatique ou hydraulique pour assurer l'alimentation/l'échappement de l'air ou de l'huile de l'alésage dudit cylindre (16).

11. Système selon l'une des revendications 1 à 7, **caractérisé en ce que** lesdits actionneurs linéaires (10) sont de type mécanique et comprennent une crémaillère entraînée par un pignon pour actionner ledit piston (18) qui agit sur l'élément de contact conducteur (5).

12. Système selon l'une des revendications 1 à 7, **caractérisé en ce que** lesdits actionneurs linéaires (10) sont de type mécanique et comprennent une vis entraînée par une tige filetée pour actionner ledit piston (18) qui agit sur l'élément de contact conducteur (5).

13. Système selon la revendication 11 ou 12, **caractérisé en ce que** ladite unité de commande (11) comprend un entraînement commandant au moins un moteur électrique.

14. Système selon la revendication 11 ou 12, **caractérisé en ce que** ladite unité de commande (11) comprend un système d'engrenages.

15. Système selon l'une des revendications précédentes, **caractérisé en ce que** ledit élément de contact conducteur (5) est disposé dans ledit cadre (7) de l'élément de fermeture mobile (4) et **en ce que** lesdits moyens de commande (10) sont montés dans ledit élément de fermeture mobile (4).

16. Système selon l'une des revendications 1 à 14, **caractérisé en ce que** ledit élément de contact conducteur (5) est disposé dans ledit jambage (6) du mur fixe (2) et **en ce que** lesdits moyens de commande (10) sont montés dans ledit mur fixe (2).

17. Système selon l'une des revendications précédentes, **caractérisé en ce que** ledit élément de contact conducteur (5) comprend une lame ou un doigt métallique,

18. Système selon l'une des revendications 1 à 17, **caractérisé en ce que** ledit élément de contact conducteur (5) comprend un joint polymère conducteur.

19. Système selon la revendication 18, **caractérisé en ce que** lesdits moyens de commande (10) comprennent des moyens d'introduction d'air destinés à introduire de l'air dans une chambre à air dudit joint de sorte à le gonfler afin d'obtenir ledit joint électromagnétique entre le mur fixe (2) et l'élément de fermeture mobile (4), directement ou en interposant un autre élément de contact conducteur (5).
